# EUROPEAN PATENT APPLICATION

(11) **EP 4 376 558 A1**
(43) Date of publication of application: **29.05.2024**
(21) Application number: 22209704.0
(22) Date of filing: 25.11.2022
(51) Int. Cl.: H05K 1/02, H05K 3/00, H05K 3/28, H05K 3/42, H05K 3/40

(54) **MANUFACTURING A COMPONENT CARRIER WITH HOLE TO BE FILLED BY A FILLING MEDIUM AND PROTECTED BY A PROTECTION LAYER**

(71) Applicant: AT & S Austria Technologie & Systemtechnik Aktiengesellschaft, 8700 Leoben-Hinterberg (AT)
(72) Inventor: Ifis, Abderrazzaq, 10250 George Town (Penang) (MY); Riedler, Jens, 8793 Trofaiach (AT)
(74) Representative: Dilg, Haeusler, Schindelmann Patentanwaltsgesellschaft mbH

(57) **Abstract**

A method of manufacturing a component carrier (100), wherein the method comprises providing a stack (102) comprising at least one electrically conductive layer structure (104) and at least one electrically insulating layer structure (106) and having a hole (112), applying a protection layer (108) at least on at least part of a horizontal surface of the stack (102) for protecting the stack (102), filling a filling medium (114) in and/or on and/or around the hole (112) in the stack (102), and subsequently removing at least part of the protection layer (108) completely from the horizontal surface and removing material of the filling medium (114) by carrying out a common material removal process.

## Description

The invention relates to a component carrier and to a method of manufacturing a component carrier.

In the context of growing product functionalities of component carriers equipped with one or more electronic components and increasing miniaturization of such components as well as a rising number of components to be mounted on the component carriers such as printed circuit boards, increasingly more powerful array-like components or packages having several components are being employed, which have a plurality of contacts or connections, with ever smaller spacing between these contacts. Removal of heat generated by such components and the component carrier itself during operation becomes an increasing issue. At the same time, component carriers shall be mechanically robust and electrically reliable so as to be operable even under harsh conditions. All these requirements go hand in hand with a continued miniaturization of component carriers and their constituents.

In particular, it may be desired to efficiently form vertical through connections in a component carrier. Such vertical through connections shall be fillable with material in a reliable way. However, a grinding process or the like which may be carried out for removing excessive filling material may damage the stack and therefore the component carrier as a whole.

There may be a need to efficiently manufacture a component carrier with filled hole and proper reliability.

According to an exemplary embodiment of the invention, a method of manufacturing a component carrier is provided, wherein the method comprises providing a stack comprising at least one electrically conductive layer structure and at least one electrically insulating layer structure and having a hole, applying a protection layer at least on at least part of a horizontal surface of the stack for protecting the stack (in particular for protecting the stack in one or more subsequent manufacturing stages), filling a (in particular temporary or permanent) filling medium in and/or on and/or around the hole in the stack, and subsequently removing at least part of the protection layer completely from the horizontal surface and removing (in particular only excessive) material of the filling medium (in particular from on and/or around the hole) by carrying out a common material removal process.

According to another exemplary embodiment of the invention, a component carrier is provided, wherein the component carrier comprises a stack comprising at least one electrically conductive layer structure and at least one electrically insulating layer structure and having a hole, and a protection layer residue arranged in the hole and configured for protecting material of the stack during at least part of a process of manufacturing the component carrier.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a sequence of two or more layer structures formed on top of each other. For instance, layer structures of a layer stack may be connected by lamination, i.e. the application of heat and/or pressure.

In the context of the present application, the term "layer structure" may particularly denote a continuous layer, a patterned layer, or a plurality of nonconsecutive islands within a common plane.

In the context of the present application, the term "hole" may particularly denote an opening in the stack. Such a hole may be a through hole extending through the entire stack, may be a blind hole extending into the stack but having a closed bottom, or may be a groove, cavity (for instance for embedding a component) or recess of any shape. During executing a method according to an exemplary embodiment, it may be possible that at least 100 holes, in particular at least 1000 holes, more particularly at least 10,000 holes, of the stack are filled partially or entirely with filling medium. It is also possible that a stack embodied as a panel-type component carrier structure comprises for example several 100,000 holes to be filled with filling medium. In such a scenario, a huge plurality of holes shall be filled in a quick, reliable, and accurate way with filling medium.

In the context of the present application, the term "protection layer" may particularly denote any coating, coverage, film, or deposit formed at least on at least part of a horizontal surface of the stack, and optionally in addition also covering at least part of a slanted or vertical surface of the stack, in particular in one or more holes formed in the stack. Moreover, said protection layer may be capable of protecting the stack from damage (in particular from undesired material removal of the stack) during a material removal process during which part of a filling medium in and/or on and/or around a hole in the stack is removed. Hence, properties of the protection layer may be adjusted to provide said protection function, in particular what concerns material robustness, thickness, shape and/or position on the stack surface. The protection layer may be provided as a sacrificial structure which can be removed, partially or entirely during and/or after removing filling medium from on and/or around a hole. For instance, a protection layer may be flat or planar or may comprise a flat or planar portion. It is also possible that a protection layer is a curved or three-dimensional structure having different (in particular interconnected or continuous, or alternatively separate) sections covering horizontal, slanted and/or vertical surface portions of the stack with its one or more holes. A protection layer may comprise a matrix material, filler particles and/or additives. The material composition of the protection layer from the mentioned and/or other constituents may allow to adjust the material properties of the protection layer.
the context of the present application, the term "protection layer residue" may particularly denote a portion of a previously applied protection layer having the above described characteristics and forming part of a readily manufactured or final component carrier. In other words, a protection layer residue may be a portion of a former and partially sacrificial protection layer, which portion is not removed by a material removal process, for instance since it is not accessible for the material removal process (for example since said portion is positioned inside the hole so that a grinding process cannot reach said protection layer residue) or since a residue portion of the protection layer cannot be fully attacked by a material removal process (for instance since it is thicker than other portions of the protection layer and is therefore only removed partially, for instance by an etching process or a process of chemically mechanically grinding).

In the context of the present application, the term "filling medium" may particularly denote any material being inserted, temporarily or permanently, into a hole so as to fill the hole partially or entirely, and in particular extending partially beyond said hole. For instance, only a bottom portion of a hole, only a circumferential portion of a hole, or only a complete volume of the hole but not an additional volume above the hole may have to be filled with a filling medium. It is also possible that not only the entire hole, but also a certain portion protruding beyond the hole shall be filled with a filling medium. A filling medium may be temporary, i.e. may fill the hole only during part of a manufacturing process and may be removed prior to completion of the manufacturing process of the component carrier. A filling medium may also be permanent, i.e. may fill the hole also in the completed component carrier. It is also possible that the filling medium in the hole is modified during a process of manufacturing component carriers, for instance a first filling medium fills a hole during a first portion of the manufacturing process and another filling medium fills the hole during a subsequent second portion of the manufacturing process. A filling medium may be electrically conductive (for instance metallic paste), magnetic (for example magnetic paste) and/or dielectric (for instance electrically insulating ink). Filling medium may also be denoted as plugin material. Filling medium may be inserted into a hole only temporarily during at least part of the process of manufacturing component carriers. It is also possible that filling medium is inserted into a hole so as to form part of a readily manufactured component carrier. The filling medium may have adjustable physical properties (for example hardness (for instance according to Mohs)) and/or chemical properties (such as resistance against oxidation, acid and/or solvents).

In the context of the present application, the term "common material removal process" may particularly denote a single common process during which both excessive hole filling medium and at least a part of protection layer material on a horizontal surface or on a horizontal surface portion of the stack are removed together at least partially simultaneously. More specifically, said horizontal protection layer or horizontal protection layer portion on the stack may be - together with said excessive filling medium - removed entirely from the horizontal stack surface by said common material removal process to thereby expose said stack surface which has been previously covered by protection layer material. Thus, the common material removal process may be a single process attacking and thereby removing both protection layer material at least on a horizontal surface of the stack and excessive hole filling medium. In particular, this may be achieved for example by a mechanical grinding process, an etching process, or a combined chemical-mechanical grinding process which attacks and thereby removes the protection layer as well as the filling medium at the same time or at least during overlapping time intervals. In particular, a contemporaneous removal of at least part of the protection layer (preferably completely) from the horizontal surface and material of the filling medium may be carried out. Hence, a common material removal process distinguishes the method from another approach in which firstly only excessive filling medium is removed by a first material removal process and only subsequently the protection layer is removed by another second material removal process, or vice versa. During a common process of removing excessive filling medium and material of the protection layer, it may also happen that at least part of the electrically conductive layer structure below can be partially removed, for instance a sub-thickness in a range from 10 nm to 5 µm thereof.

In particular, the stack or the entire component carrier may comprise two opposing main surfaces. The main surfaces may form the two largest surface areas of the stack or component carrier. The main surfaces are connected by circumferential side walls. The thickness of a stack or component carrier is defined by the distance between the two opposing main surfaces. The main surfaces may comprise functional sections, such as conductive traces or conductive interconnections with further elements. Said definition of the term main surface may apply, mutatis mutandis, also to other structures described herein.

According to an exemplary embodiment of the invention, a protection layer may be formed at least on at least part of a horizontal surface (and optionally also on at least part of a vertical or slanted surface) of a (preferably laminated) layer stack of a component carrier to be manufactured. Said protection layer may be configured to protect the stack against undesired influences (in particular against undesired removal of stack material) during at least part of a component carrier manufacturing process. A (for example metallic, magnetic and/or dielectric, for instance temporary or permanent) filling medium may be applied into one or more holes (for instance laser drilled or mechanically drilled through holes) in the stack. During such a hole filling process, it may also happen that filling medium is also applied (for example unintentionally) to undesired portions, for instance protruding beyond said hole in an upward and/or in a downward direction. For removing excessive filling medium, it may be possible to subsequently remove at least part of the protection layer completely from the horizontal surface, while removing at the same time as well excessive material of the filling medium. Advantageously, said combined protection layer and filling medium material removal may be executed by a common material removal process, i.e. simultaneously or at least in a temporary overlapping manner. More specifically, a process of removing filling medium may also attack at least a horizontal portion of the protection layer. Consequently, the removal of excessive filling medium may be carried out in a quick way while ensuring that the stack is properly protected against damage (such as unintentional stack thinning) during trimming filling medium filling a stack hole. Descriptively speaking, the protection layer or at least a horizontal part thereof may function as a sacrificial structure which is removed during fulfilling and/or after having fulfilled its function.

According to another exemplary embodiment, the described manufacturing method may lead to a protection layer residue remaining in part of a hole of a readily manufactured component carrier. For example, a protection layer residue which functioned as part of the protection layer for protecting a stack surface during part of a component carrier manufacturing process may line at least a portion of a sidewall of a hole being properly filled with filling medium in the final component carrier. This may be thanks to a common material removal process during which excessive filling medium and only part of the protection layer - but not the protection layer residue - has been removed. Thus, a protection layer residue may continuously function as a protection for critical surface portions (such as an edge or a transition region between an interior and an exterior of the hole) in and/or around a hole filled at least partially with a filling medium.

In the following, further exemplary embodiments of the component carrier and the method will be explained.

In an embodiment, the method comprises applying the protection layer on the entire horizontal surface of at least one main surface of the stack, in particular on both opposing main surfaces of the stack. In particular a conformal deposition of the protection layer on the entire horizontal surface of the stack of one or both opposing main surfaces thereof may reliably protect the stack against damage during abrasively treating filling medium in a stack hole. During the common material removal process, all portions of the protection layer on horizontal surface regions of the stack may be removed.

In an embodiment, the method comprises applying part of the protection layer on at least part of a slanted or vertical surface of the hole extending into, in particular through, the stack. Hence, the slanted or vertical surface may be covered by the protection layer partially or entirely. Advantageously, one or more portions of a protection layer on a slanted or vertical surface of the hole may be prevented from being removed during a common material removal process for removing horizontal portions of a protection layer as well as excessive filling medium extending beyond a respective hole. As a result, slanted or vertical portions of the protection layer may still protect assigned surface portions of the hole even after having completed a method of manufacturing a component carrier.

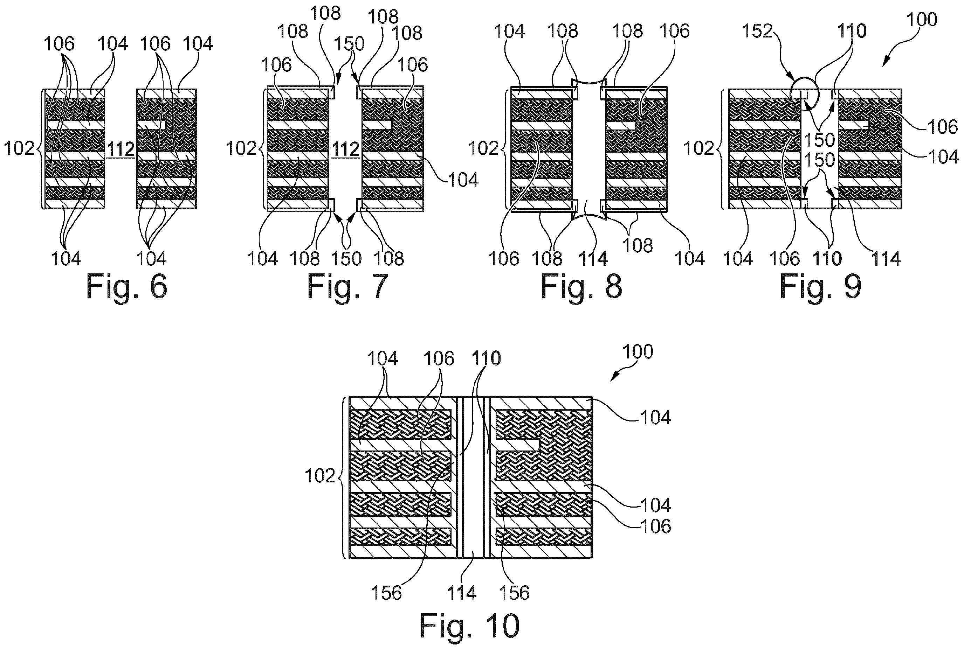

In an embodiment, the method comprises applying the protection layer on said at least part of the horizontal surface of the stack and on a connected part of a slanted or vertical surface of the hole extending into, in particular through, the stack. In particular, slanted or vertical surface portions of the stack delimiting the hole and being covered with the protection layer may be exclusively those which are located directly next to a horizontal surface of the stack, whereas surface portion in a central interior of the hole may remain free of the protection layer (see for instance Figure 7). As a result, specifically critical edge or corner portions between an exterior horizontal surface of the stack and slanted or vertical sidewalls delimiting a stack hole may be protected by a protection layer applied there. Descriptively speaking, a corresponding protection layer may have an L-shape in such a corner portion (see again Figure 7). In a transition between slanted or vertical and horizontal surface portions of the stack, the risk of damage during processing may be particularly pronounced. Continuously covering such a transition portion between horizontal sections and slanted or vertical sections by the protection layer may ensure mechanical integrity of the stack during a material removal process even in critical regions.

In an embodiment, the method comprises applying the protection layer on a region of the stack from which no material of the stack is to be removed when carrying out said common material removal process. Surface portions of the stack covered with the protection layer may be prevented from being damaged or unintentionally thinned during the material removal process, since they may be formed with attributes (in particular thickness, hardness and/or robustness against the material removal process) so that they withstand a mechanical and/or chemical impact during the material removal process.

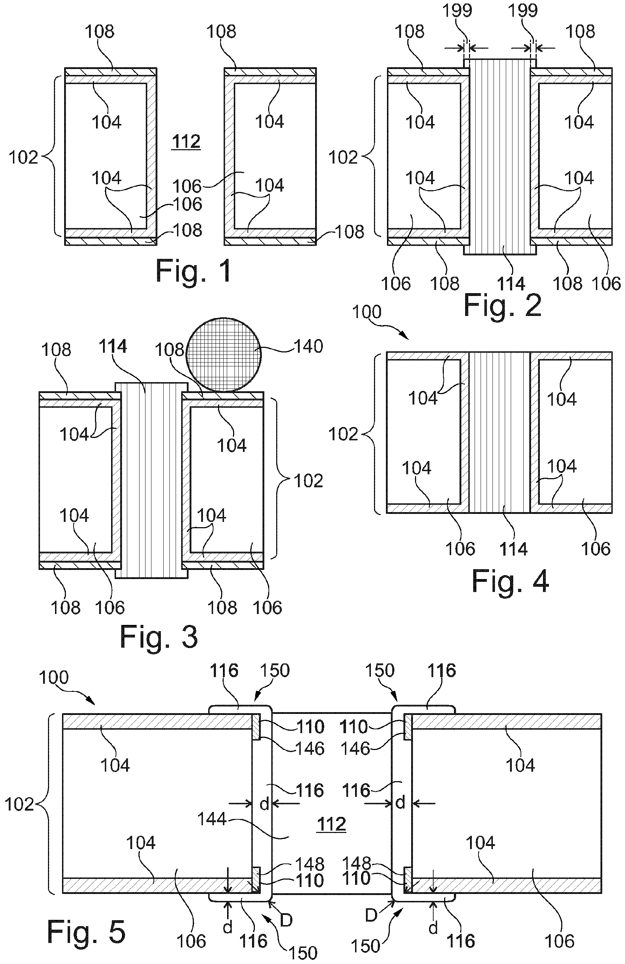

Said region of the stack from which no material is to be removed may overlap laterally with another region from which filling medium is to be removed by said common material removal process (see reference sign 199 in Figure 2). A corresponding scenario is shown in Figure 2: In particular, the filling medium may be applied into the hole - and an excessive part on top thereof - after having previously formed the protection layer at least on a horizontal surface of the stack. During such a process, it may also happen that excessive filling medium accumulates not only on top of the hole but also partially laterally thereof on the protection layer. Such a lateral excessive portion of the filling medium on the protection layer may lead to a lateral overlap between protection layer and excessive filling medium in lateral direction. When said lateral excessive portion is then removed, the protection layer may specifically provide protection in the overlapping portion.

In an embodiment, the method comprises applying another part of the protection layer to cover an entire sidewall of the hole. In such an embodiment, the entire slanted or vertical surface of a respective hole in the stack may be covered with a protection layer (see for instance Figure 10). This may lead to a temporary or even permanent lining of a circumferential sidewall delimiting the respective stack hole for enhancing the protection.

In an embodiment, said removing comprises removing selectively the part of said filling medium extending vertically beyond the horizontal surface of the stack. During the same material removal process, the protection layer may be removed from the horizontal main surface of the stack only, whereas slanted or vertical surface portions of the protection layer inside of the hole may remain even after the common material removal process. This may be achieved by executing a material removal process which only operates on the accessible horizontal surface portions apart from the holes. For instance, a purely mechanical grinding process for removing protection layer material will only attack accessible protection layer portions on the main surfaces of the stack, but not inside of the holes.

In an embodiment, the common material removal process is a pure mechanical grinding process, a pure chemical material removal process, or a combined mechanical grinding and chemical material removal process. Purely mechanically grinding may denote abrasive machining of protection layer and filling medium for which a grinding body (such as a grinding wheel) may be used as abrasive tool. In a pure chemical material removal process, an etchant or another chemical agent may be applied for triggering a chemical attack on the protection layer and the filling medium which leads to a removal of at least part thereof. In yet another embodiment, it is also possible to combine mechanical grinding and material removal by chemistry, for instance by applying chemical-mechanical abrasion. To put it shortly, such an embodiment may enhance material removal by adding a material removal promoting chemistry to a mechanically abrasive grinding process.

In an embodiment, the method comprises applying the protection layer before applying the filling medium, i.e. before a plug-in process. By taking this measure, it may be ensured that a target area of the stack is properly protected and that also excessive filling medium accumulating on top of the protection layer can be removed efficiently by the common material removal process. This may combine a reliable protection of the stack with a complete removal of excessive filling medium.

In an embodiment, the method comprises applying the protection layer before said material removal process. Hence, already at the beginning of the material removal process, formation of the protection layer may be already completed. This may ensure a reliable protection of the stack during the entire material removal process.

In an embodiment, the method comprises removing the protection layer completely by said common material removal process. In such an embodiment, no protection layer at all remains in the readily manufactured component carrier. This may be advantageous in particular in a scenario in which it is desired that the interior of the stack does not comprise any foreign material originating from the protection layer. For example, the complete removal of the protection structure may be advantageous in order to keep a coefficient of thermal expansion (CTE) mismatch small by ensuring that no protection layer with significantly different CTE value compared with the stack is present.

In another embodiment, the method comprises removing only part of the protection layer by said common material removal process without removing a protection layer residue, in particular located inside of the hole. Hence, it may be advantageous that a selected part of the protection layer remains permanent part of the component carrier. Such a protection layer residue may provide at least one function in the readily manufactured component carrier, for instance its intrinsic protection function, a shielding function, the function of providing reliable electric isolation in a stack portion or even contributing to an electric connection in the stack.

In an embodiment, the protection layer is applied as a material adhering to metal, in particular to copper material, more particularly of the at least one electrically conductive layer structure. Correspondingly, the protection layer residue may comprise a material adhering to copper material, in particular of the at least one electrically conductive layer structure. Frequently, component carriers such as printed circuit boards or integrated circuit substrates comprise an electrically conductive wiring comprising copper. When ensuring that the protection layer properly adheres to copper, undesired delamination between the protection layer and copper structures of the stack (in particular of electrically conductive layer structures of the stack) may be reliably prevented. Such an undesired delamination or separation between the protection structure on the one hand and copper structures of the stack on the other hand might deteriorate the protecting function of the protection structure during the common material removal process. By ensuring a proper adhesion between copper and protection structure material, a high mechanical integrity of the obtained component carrier and the stack may be achieved.

In an embodiment, the protection layer is applied as a dielectric material, in particular by laminating. Accordingly, the protection layer residue may comprise a dielectric material, in particular a dry film material. In such an embodiment, an electrically insulating protection layer may be applied to the stack by the application of pressure and/or heat. In particular a dry film turned out as particularly appropriate for said purpose.

In another embodiment, the protection layer is applied as a metallic material, in particular by plating and/or sputtering. Correspondingly, the protection layer residue may comprise a metallic material, in particular nickel, palladium, and/or hardened or oxidized copper. For example, the protection layer may be formed as a plated or sputtered copper layer, which can be hardened or oxidized. Such a copper is perfectly compliant with component carrier technology, such as PCB or IC substrate technology. Furthermore, copper and/or other appropriate metallic materials (such as nickel) can be applied by physical vapor deposition, more specifically sputtering. In particular, a metallic protection layer may be formed by galvanic plating and/or electroless plating. Excellent results can be achieved when forming the protection layer from hardened or oxidized copper.

In an embodiment, the protection layer and/or the protection layer residue may comprise an organic material or an organic compound, in particular a resin. An organic compound may be a chemical compound that contains carbon-hydrogen bonds. Preferably, said organic material may comprise e.g. polyimide and/or epoxy resin. This may have the advantage of a good adhesion to electrically conductive material, e.g. copper, and may provide high-throughput manufacturing.

In an embodiment, the protection layer residue lines at least part of a sidewall of the hole, in particular a through hole, extending into the stack. For instance, part of or even an entire hollow cylindrical sidewall delimiting a hole in the stack may be covered with the protection layer residue. Then, the protecting effect of the protection layer can be experienced over the entire extension of the hole.

In an embodiment, the protection layer residue is a circumferentially closed structure (for instance a sleeve structure) in the hole in the stack. Advantageously, the protection layer residue may act as an anchor structure to ensure that a filling medium stays in place. For example, said circumferentially closed structure may have a circular, oval, or polygonal (in particular rectangular and more particularly quadratic) outline. Circumferentially closing the protection layer residue may enhance the mechanical stability provided by said protection layer residue.

In an embodiment, the protection layer residue comprises an annular structure at an exterior end of said hole (see for example the upper end portion or the lower end portion of the hole in Figure 9). Hence, at least part of a circumferentially closed structure may be arranged at an edge between the hole in the stack and a horizontal surface of the stack. This may specifically protect a critical corner region between a horizontal surface of the stack and a vertical surface of the stack hole while keeping a major portion of the hole surface free of a protection layer residue.

In an embodiment, the protection layer residue comprises a further separate annular structure at an opposing other exterior end of said hole being a through hole (see for example the upper end portion and the lower end portion of the hole in Figure 9). In such an embodiment, both opposing critical corner regions between a respective stack main surface and a respective end portion of a through hole extending through the entire stack may be reliably protected during the common material removal process.

In an embodiment, the protection layer residue comprises a hollow cylindrical structure lining an entire surface of a sidewall delimiting said hole (see for example Figure 10). This may also mechanically strengthen the entire wall surface of a hole extending into or through the stack.

In an embodiment of the component carrier, the hole in the stack is filled at least partially with a filling medium, in particular a dielectric filling medium, a metallic filling medium, or a magnetic filling medium. For example, the filling medium comprises a dielectric ink, a metallic paste, a metallic plating structure, and/or a magnetic paste. In one embodiment, a dielectric ink may be filled in one or more holes of a component carrier for preventing voids in an interior of component carrier. Dielectric ink filled holes may define regions in which no electricity shall be conducted. However, it may also be possible to fill holes of a component carrier with metallic paste for instance for preparing a solder or sinter process (for instance solder paste or sinter paste) or for creating desired electric circuits (for instance on the basis of copper paste or ink). It is also possible to plate metal in at least part of the hole, for instance by electroless plating and/or electroplating. Furthermore, magnetic paste (for instance a ferrite paste) may be filled in holes of a component carrier, for example for electromagnetic shielding purposes or for implementing magnetic functionality (such as a coil with magnetic core filling) in the component carrier.

In an embodiment, a thickness of a plated electrically conductive layer at an edge between a horizontal surface of the stack and the hole extending in the stack is at least 5 µm, in particular at least 20 µm. Other values are possible for certain applications. Providing a plated electrically conductive layer in a corner region between a horizontal stack surface and a slanted or vertical hole extending into the stack may ensure a reliable electric connection specifically in said critical corner region. For example, said edge-positioned plated electrically conductive layer may form part of the protection layer or of the protection layer residue, or may be separately therefrom (for example is formed at least partially on top thereof). When a thickness at the corner or edge is at least 5 µm, an undesired interruption of a metallic lining in the corner region may be reliably prevented. Advantageously, such a metallic corner lining may also be reliably maintained after grinding (as an example for the common material removal process).

In an embodiment, a ratio between a thickness of a plated electrically conductive layer at an edge between a horizontal surface of the stack and the hole extending in the stack on the one hand and a thickness of said plated electrically conductive layer apart from the edge, in particular at the horizontal surface and/or in the hole, is larger than 1, in particular is in a range from 1.1 to 1.3. Hence, the metallic lining in the corner region between main surface of the stack and the stack hole may be selectively thickened in comparison with a lining of the hole in an interior central section thereof. This may ensure that a reliable electric connection remains established also in the critical corner section.

In an embodiment, the stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres, or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer, or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.
Figure 1 to Figure 4 illustrate cross-sectional views of structures obtained during carrying out a method of manufacturing a component carrier, shown in Figure 4, according to an exemplary embodiment of the invention.
Figure 5 illustrates a schematic cross-sectional view of a component carrier according to an exemplary embodiment of the invention.
Figure 6 to Figure 9 illustrate cross-sectional views of structures obtained during carrying out a method of manufacturing a component carrier, shown in Figure 9, according to an exemplary embodiment of the invention.
Figure 10 illustrates a schematic cross-sectional view of a component carrier according to an exemplary embodiment of the invention.
Figure 11 and Figure 12 illustrate cross-sectional views of structures obtained during carrying out a method of manufacturing a component carrier according to an exemplary embodiment of the invention.
Figure 13 illustrates an image of a component carrier according to an exemplary embodiment of the invention.
Figure 14 illustrates a cross-sectional view of a structure obtained during carrying out a method of manufacturing a component carrier according to an exemplary embodiment of the invention.
Figure 15 and Figure 16 illustrate cross-sectional views of structures obtained during carrying out a method of manufacturing a component carrier, shown in Figure 16, according to an exemplary embodiment of the invention.
Figure 17 to Figure 20 illustrate cross-sectional views of structures obtained during carrying out a method of manufacturing a component carrier, shown in Figure 20, according to an exemplary embodiment of the invention.
Figure 21 illustrates a schematic cross-sectional view of a component carrier according to an exemplary embodiment of the invention.
Figure 22 illustrates a schematic cross-sectional view of a component carrier according to an exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, a protection layer may be formed which may partially or entirely cover a horizontal surface of a (preferably laminated) layer stack of a component carrier (such as a printed circuit board or an integrated circuit substrate) to be manufactured. Said protection layer may function for protecting a horizontal surface, and preferably in addition also a vertical surface, of the stack (in particular during one or more subsequent manufacturing stages of manufacturing the component carrier, for instance on panel level), in particular for protecting the stack against undesired thinning or damaging during a subsequent filling medium removal process. When executing the method, it is possible to fill a filling medium (such as dielectric ink or metallic paste) partially in a stack hole and partially outside of said the stack hole. Thereafter, excessive filling medium (in particular a portion of the filling medium apart from the stack hole) may be removed together with the horizontal protection layer, i.e. to remove the latter completely at least from the horizontal surface. Thus, excessive filling medium (in particular a portion thereof which is arranged outside of said stack hole) may be removed simultaneously and together with at least the horizontal part of the protection layer. This may be accomplished preferably by a combined grinding process which removes excessive filling medium by grinding and removes at the same time protection layer material by said grinding. Said simultaneous and consequently quick and efficient material removal of filling medium and protection layer may be executed by carrying out a common material removal process. Further advantageously, this may ensure that the stack is reliably protected during the hole filling process and that the horizontal main surfaces of the stack can be finally exposed with respect to the protection layer material. Thus, the horizontal surface of the stack is thereafter fully available for further processing or use of the component carrier without being covered any longer by the horizontal protection layer. However, a portion of the protection layer in the hole may form a permanent part of the manufactured component carrier as protection layer residue. In the component carrier, such a protection layer residue may still fulfill a protection function in particular in a critical corner region between hole and exterior main surface of the stack.

In conventional approaches, filling holes of a stack of a component carrier during its manufacturing process may lead to undesired copper voids, resin residues, and damage of base material at the level of the holes or below. Moreover, conventional approaches may suffer from a high copper thickness variation on the surface. This may lead, in turn, to critical etching process control, a high variation of impedance, and a low signal integrity. Moreover, wrap plating violation during conventional approaches may even result in corner crack under stress.

In order to overcome at least part of the above-mentioned and/or other conventional shortcomings, exemplary embodiments of the invention may provide a protection or sacrificial layer at least on a horizontal surface thereof prior to grinding for trimming filling medium in a hole of a stack of a component carrier. Hence, it may be advantageously possible to apply a protection layer or a sacrificial layer to a targeted stack surface prior to hole-plugging and grinding. Due to the protection of the stack during hole filling and trimming of filling medium, the stack may be reliably protected against damage. This may increase the yield and reliability of the manufactured component carrier. Further, this may improve the quality of the manufactured component carrier and may therefore have a positive impact on signal performance during operation of the manufactured component carrier.

By providing one or more protective and sacrificial layers on dedicated surface portions of a stack prior to grinding excessive hole filling medium, it may be possible to obtain a high yield. In particular, this may render it possible to prevent resin residues, copper voids, base material damages, thickness variation, etc.

Moreover, exemplary embodiments of the invention may allow to obtain a high process control. Furthermore, the described manufacturing process may lead to an accurate copper surface distribution, and consequently to a high signal integrity. Beyond this, a high reliability may be achieved by preventing wrap plating violation.

Exemplary applications of exemplary embodiments of the invention are all types of component carriers (in particular PCBs and IC substrates) requiring plug-in of filling medium in holes thereof. In particular, mobile communication applications, automotive applications and aircraft applications are possible using a component carrier according to an exemplary embodiment of the invention. Furthermore, exemplary embodiments may relate to a component carrier with magnetic function, which may be achieved for example by filling a magnetic filling medium in the stack for forming inductors, etc. Moreover, exemplary embodiments may enable a high-quality hole protection, which may be of utmost advantage for high-quality applications.

An experimental analysis has shown that in particular nickel and palladium are promising materials which may be used for creating a protection layer.

Advantageously, plugin and grinding processes carried out by exemplary embodiments may provide significant benefits for advanced applications.

According to an exemplary embodiment, a method of manufacturing a component carrier is provided, wherein a protection layer is applied at least to an exposed horizontal surface of a laminated layer stack prior to grinding for removing excessive plugin material filled in holes of the stack.

Grinding is an aggressive mechanical process that generates excessive heat and mechanical stress. The high level of thermomechanical stress may lead to a damage of the base material (i.e. of the stack) and also to the formation of undesired copper voids on a ground surface. In order to overcome such shortcomings, an exemplary embodiment of the invention adds a protection layer to a targeted surface of the stack prior to a plugin and grinding process. This protection layer can be made for example of protection material with high hardness to fully protect the copper surface from grinding abrasion and the base material of the stack from generated heat. In particular, the protection layer may be configured as sacrificial layer that may also be removed during grinding but allows a lower reduction of the surface copper thickness.

When applied before plug-in, the protection layer or film may protect the copper surface from the grinding abrasion leading to less copper voids and base material damages. The selected material of the protection layer should have a high wear resistance (such as nickel, palladium, titanium). An appropriate material (as for example the mentioned materials) should further have a high thermal resistance, high hardness and a low degree of dislocation which may also allow atomic movement and low abrasion.

The present inventors have carried out tests which lead to the result that palladium provides a highly reliable protection even when provided with a relatively small thickness of lower than 0.2 µm. Also nickel shows an acceptable wear resistance at a thickness of 4 µm. Thus, nickel is highly appropriate as a sacrificial layer which is entirely removed from the stack after having provided a protection function.

In case of cladded cores where plug-in may be done prior to plating, a carrier foil can be a good protective and sacrificial film. Descriptively speaking, the carrier may protect the copper surface during grinding.

Still in case of cores, a plated copper surface formed prior to grinding can also be used to protect the base layer. It may be preferable to thermally treat the plated copper in a ramp mode to harden the surface and make it more wear resistant.

Furthermore, a protection layer may be formed of an organic or composite coating which allows to create a protection layer with particularly low effort and cost.

To put it shortly, exemplary embodiments of the invention may ensure a good copper distribution control allowing to obtain low yield loss due to grinding. More particularly, it may also be possible in exemplary embodiments of the invention to get an accurate control of the impedance and signal performance. Concluding, high quality, reliability, yield, signal performance and processability may be achieved by exemplary embodiments of the invention. The manufacturing architecture according to exemplary embodiments of the invention may enhance design and specification control and may allow to manufacture even complex designs with high signal integrity.

Figure 1 to Figure 4 illustrate cross-sectional views of structures obtained during carrying out a method of manufacturing a component carrier 100 according to an exemplary embodiment of the invention. The readily manufactured component carrier 100 is illustrated in Figure 4 and may be an integrated circuit (IC) substrate or a printed circuit board (PCB).

**Figure 1** shows a cross-sectional view of a laminated layer stack 102 comprising one or more electrically conductive layer structures 104 and one or more electrically insulating layer structures 106. For example, the electrically conductive layer structures 104 may comprise continuous or patterned metal layers (such as patterned copper foils or patterned deposited copper layers) and vertical through connections, for example copper filled vias, which may be created by drilling and plating. The one or more electrically insulating layer structures 106 may comprise a respective resin (such as a respective epoxy resin), preferably comprising reinforcing particles therein (for instance glass fibers or glass spheres). For example, the electrically insulating layer structures 106 may be made of FR4. The electrically insulating layer structures 106 may also comprise resin layers being free of glass (in particular glass fibers).

As shown in Figure 1 as well, a through hole 112 (alternatively a blind hole, recess or cavity) is formed in stack 102 to extend vertically through the entire stack 102. More specifically, through hole 112 extends vertically between an upper main surface and a lower main surface of the laminated layer stack 102. For instance, through hole 112 may be formed by mechanically drilling or by laser drilling.

More specifically, Figure 1 shows a central electrically insulating layer structure 106, which may for example be a core. Two copper foils may be attached to the two opposing main surfaces of the electrically insulating layer structure 106 to thereby form the illustrated horizontal electrically conductive layer structures 104. Sidewalls delimiting the through hole 112 may be coated or lined with an electrically conductive material such as copper, which may be formed for example by plating. Such a plating process may for example comprise electroless plating for forming a thin metallic seed layer followed by galvanic plating.

After having completed formation of stack 102, a respective protection layer 108 may be applied to the entire surface area of both opposing horizontal main surfaces of the stack 102. Hence, the protection layers 108 are fully aligned with the stack 102 according to Figure 1. The protection layers 108 may function for protecting the laminated layer stack 102 during subsequent manufacturing processes for manufacturing component carrier 100, in particular during a process of trimming a filling medium 114 filling through hole 112, as described below.

Hence, the protection layers 108 are formed on the entire horizontal surface of the stack 102, and on both opposing main surfaces thereof. No protection layer 108 is formed on the sidewalls of the through hole 112 in the embodiment of Figure 1. In order to obtain the structure shown in Figure 1, it is for instance possible to laminate protection layers 108 to both opposing main surfaces of the stack 102. For instance, a dielectric dry-film-type protection layer 108 may be used for this purpose. In the shown embodiment, each protection layer 108 may thus be applied as a dielectric material, for instance as a dielectric dry film applied by laminating. Preferably, the protection layer 108 may be applied as a material adhering properly to a metal, in particular copper material, of the electrically conductive layer structures 104 on the exterior horizontal main surfaces of the stack 102. Additionally, an adhesive layer may be in between the electrically conductive layer structure 104 and the protection layer 108 (not shown in the Figure).

In another environment, it may also be advantageous to apply the respective protection layer 108 as a metallic material, for instance by galvanic plating and/or by sputtering. A preferred metallic material of the protection layer 108 is palladium due to its excellent compatibility with copper and due to its high mechanical strength. Consequently, a palladium protection layer 108 may be highly appropriate for protecting stack 102 during a subsequently described material removal process (in particular by grinding). Hardened or oxidized copper or nickel may be other advantageous options for a metallic protection layer 108.

When laminating the protection layers 108 to the main surfaces of the stack 102, the protection layer 108 may be created specifically on a region of the stack 102 from which no stack material shall be removed during a material removal process described below referring to Figure 3.

Still referring to Figure 1, the protection layers 108 are embodied as additional films applied only on the horizontal surface portions of the stack 102. However, it is also possible that such a protection layer 108 is formed inside of the one or more holes 112, i.e. partially or entirely on the vertical sidewalls delimiting the hole 112.

In an embodiment, the protection layers 108 can be sacrificial, so that they are automatically fully removed during a below described material removal process. Alternatively, a protection layer 108 can also be formed partially inside of hole 112 so that part of the protection layer 108 (which may be denoted as protection layer residue 110) may remain after a material removal process of removing excessive filling medium. Such a protection layer residue 110 may then form part of the final component carrier 100.

Referring to **Figure 2****,** a filling medium 114 may be filled partially in, partially on, and partially around the hole 112 in the stack 102 in a plug-in process. For example, this may be accomplished by moving a squeegee over the structure shown in Figure 1 to press filling medium 114 into the holes 112. However, it is also possible to provide a medium applicator with a print head (not shown) for printing the filling medium 114 in the holes 112 of the stack 102. This printing process may be an injection printing process. Hence, after having applied the protection layer 108 to the horizontal main surfaces of the stack 102 as described referring to Figure 1, the filling medium 114 may be inserted into the through hole 112. As shown in Figure 2, part of the filling medium 114 may properly fill the through hole 112, whereas another part of the filling medium 114 may protrude vertically and/or laterally beyond the through hole 112. The latter mentioned other part of the filling medium 114 may be denoted as excessive filling medium.

Again referring to Figure 2, the portion of the filling medium 114 which protrudes laterally beyond the through hole 112 overlaps with the protection layer 108 directly adjacent to the through hole 112 in an overlapping region denoted with reference sign 199. Hence, a protected region of the stack 102 from which no stack material is to be removed when carrying out a later common material removal process overlaps laterally in the overlapping region 199 with another region of the structure of Figure 2 from which filling medium 114 is to be removed by said common material removal process.

Referring to **Figure 3****,** the structure shown in Figure 2 may then be subjected to a material removal process, which is here embodied as a grinding process. More specifically, the structure shown in Figure 2 is subjected to grinding by guiding abrasive grinding tool 140 along the upper main surface and along the lower main surface of the structure shown in Figure 2. Grinding may be carried out on both opposing main surfaces of the structure shown in Figure 2 simultaneously or subsequently.

By said grinding process, the protection layers 108 are removed completely from the horizontal surfaces of stack 102. Simultaneously, i.e. by the same respective grinding process, excessive filling medium 114, i.e. the portion of the filling medium 114 protruding vertically and laterally beyond the through hole 112, may be removed as well. Removing each respective protection layer 108 and removing corresponding excessive filling medium 114 may be accomplished by carrying out a common grinding process. More generally, a common material removal process may be executed, for example separately on each main surface, for removing the horizontal protection layers 108 as well as the excessive filling medium 114. Grinding, as an example for a common material removal process, is a pure mechanical material removal process. Other pure mechanical material removal processes may be carried out as well, for instance routing. However, it is alternatively also possible that the common material removal process is a pure chemical material removal process (such as etching, for instance wet etching), or a combined mechanical and chemical material removal process (such as an abrasive mechanical process supported by a material removing chemistry). Also a plasma process may be executed as the common material removal process.

Referring to **Figure 4****,** it can be seen that the horizontal protection layers 108 have been removed completely by said common material removal processes. Also part of the filling medium 114 has been removed so that the laminated layer stack 102 and the filling medium 114 constitute together a flat or planar geometry on both opposing main surfaces.

In order to further improve the quality of the exposed main surfaces of the component carrier 100 shown in Figure 4, it may be possible to subject one or both opposing main surfaces to an appropriate surface treatment, such as plasma treatment.

**Figure 5** illustrates a schematic cross-sectional view of a component carrier 100 according to an exemplary embodiment of the invention.

The shown component carrier 100 comprises a laminated layer stack 102 composed of one or more electrically conductive layer structures 104 (for instance made of copper) and one or more electrically insulating layer structures 106 (for instance one or more sheets of prepreg, FR4, resin, etc.). Again, a through hole 112 extends vertically through the entire stack 102.

For manufacturing component carrier 100 of Figure 5, protection layers 108 (not shown in Figure 5) may be temporarily applied to the horizontal main surfaces of stack 102, for example in the way described referring to Figure 1 to Figure 4. Moreover, it is also possible according to Figure 5 that a portion of the protection layers 108 is formed to line part of the vertical sidewalls of the stack 102 delimiting through hole 112. Furthermore, it is possible that such a vertical portion of a protection layer 108 is not removed during the common material removal process which removes part of a filling medium 114 and horizontal protection layers 108, as described referring to Figure 1 to Figure 4. One or more remaining vertical portions of such a protection layer 108 which may form part of the final component carrier 100 of Figure 5 can be denoted as protection layer residue(s) and are indicated by reference signs 110 in Figure 5. Figure 6 to Figure 9 described below show a manufacturing method in which a protection layer residue 110 of the type shown in Figure 5 can be obtained. Since corner regions between horizontal surface portions and vertical surface portions of the stack 102 with through hole 112 may be particularly prone to damage during a manufacturing process, covering said corner regions in the through hole 112 with portions of protection layer 108 leading to the protection layer residue 110 according to Figure 5 may be of utmost advantage. During the mentioned manufacturing process, the through hole 112 may also be temporarily filled with a filling medium 114 (for instance for preventing resin or foreign particles from accumulating in through hole 112), which is not shown in Figure 5. For completing the manufacturing process of component carrier 100, it can also be possible to later remove such a temporary filling medium 114 from the through hole 112 and substitute it by another filling of the through hole 112, as shown in Figure 5. Said other filling of the through hole 112 according to Figure 5 comprises a metallic lining or plated electrically conductive layer 116 (which is U-shaped in the cross-sectional view of Figure 5) covering the vertical sidewalls delimiting through hole 112 and covering connected portions of the horizontal main surfaces of stack 102. As shown, the plated electrically conductive layer 116 extends along corner regions between horizontal and vertical surface regions of stack 102 and also covers the protection layer residue 110. A remaining empty volume of the through hole 112 may then be filled with a metal plating filling 144. Metal plating filling 144 may for instance be manufactured by executing one or more galvanic plating stages. For example, plated electrically conductive layer 116 and/or metal plating filling 144 may be made of copper. The described process is in particular advantageous for higher aspect ratios, i.e. for higher ratios between vertical thickness and diameter.

In the following, construction of component carrier 100 of Figure 5 obtained from the described manufacturing method will be explained in further detail:
As already mentioned, protection layer residue 110 is arranged in the through hole 112 of the laminated layer stack 102 and is configured for protecting material of the stack 102 during the process of manufacturing the component carrier 100. According to Figure 5, the protection layer residue 110 is composed of two separate vertically spaced annular structures and lines two circumferential portions of the sidewall of the through hole 112 extending completely through the stack 102. More specifically, the protection layer residue 110 comprises an upper annular structure 146 at an upper exterior end of said through hole 112. Furthermore, the protection layer residue 110 comprises a separate lower annular structure 148 at an opposing lower exterior end of said through hole 112. Each of the two unconnected substructures 146, 148 of the protection layer residue 110 is here embodied as a circumferentially closed structure in the through hole 112 in the stack 102. Furthermore, each of the two unconnected substructures 146, 148 of the protection layer residue 110 forms a circumferentially closed structure arranged at a respective upper or lower edge between the hole 112 in the stack 102 and a horizontal surface of the stack 102. Thus, the substructures 146, 148 of the protection layer residue 110 are advantageously positioned at the critical corner regions and provide a valuable protection exactly where mostly needed.

Moreover, the through hole 112 in the stack 102 is filled additionally by the above described plated electrically conductive layer 116 on the sidewalls of the through hole 112 and by the metal plating filling 144 on the metallic lining. Advantageously, the protection layer residue 110 may comprise a material adhering properly to the copper material of the electrically conductive layer structures 104 and the electrically conductive layer 116 to which the protection layer residue 110 is connected according to Figure 5. For instance, the protection layer residue 110 may comprise a metallic material, such as palladium, nickel and/or hardened or oxidized copper.

As already mentioned, edge or corner regions 150 between horizontal and vertical surface areas of stack 102 with through hole 112 may be particularly critical what concerns stability, the risk of cracks, reliability of a continuous metallic coverage, etc. With the described manufacturing process, it may be ensured that a thickness D of the plated electrically conductive layer 116 at a respective edge between a horizontal surface of the stack 102 and the through hole 112 extending through the stack 102 is at least 5 µm. Preferably, thickness D may be at least 20 µm. Another advantageous design rule in terms of reliability of component carrier 100 is that a ratio between the thickness D of the plated electrically conductive layer 116 at a respective edge between a horizontal surface of the stack 102 and the hole 112 extending in the stack 102 on the one hand and a thickness d of said plated electrically conductive layer 116 apart from the edge, more precisely at the horizontal surface and/or in the through hole 112, is larger than 1, and is preferably in a range from 1.1 to 1.3. To put it shortly, a sufficiently thick electrically conductive layer 116 in the corner regions 150 (as defined by the above-mentioned design rules) may lead to a high reliability of component carrier 100.

Figure 6 to Figure 9 illustrate cross-sectional views of structures obtained during carrying out a method of manufacturing a component carrier 100 according to an exemplary embodiment of the invention.

**Figure 6** shows a laminated layer stack 102 with through hole 112, as explained above. The through hole 112 may be formed by mechanically drilling. Figure 6 shows an example of non-plated holes.

Referring to **Figure 7****,** protection layers 108 are applied to fully cover the horizontal main surfaces of stack 102. In addition, part of the respective protection layer 108 extends partially up to a vertical surface of the through hole 112 extending through the stack 102. Descriptively speaking, the protection layers 108 are L-shaped in the illustrated cross-sectional view of Figure 7. As shown, the respective long leg of each L-shaped structure of a respective protection layer 108 extends horizontally on a main surface of the stack 102. Correspondingly, the respective short leg of each L-shaped structure of a respective protection layer 108 extends vertically into the through hole 112 formed in the stack 102. Advantageously, each vertical section of the respective protection layer 108 specifically protects the critical corner regions 150. Thus, the protection layers 108 may be applied partially on the horizontal surface of the stack 102 and partially on a connected part of a vertical surface of the through hole 112 extending through the stack 102.

For the protection layers 108, materials with high resistance to wear and abrasion may be highly appropriate, for instance nickel. Nickel may be in particular an appropriate choice when the one or more through holes 112 are of a non-plated type. For instance, a corresponding protection layer 108 can be deposited chemically, by vapour deposition or by plating. Also a hardened or oxidized copper structure can be used as a sacrificial layer forming a respective protection layer 108.

However, other materials can be used as well for the protection layers 108, for instance a dry film laminate. A dry film may be in particular an appropriate choice when the one or more through holes 112 are of a plated type.

Generally, appropriate materials to protect layer 108 shall adhere to copper and should not be harmful for the operation of the final component carrier 100 (for example shall not deteriorate signal integrity).

**Figure 8** illustrates that the through hole 112 of Figure 7 is filled with a filling medium 114. For instance, filling medium 114 may be a magnetic paste, a metallic paste, or a dielectric ink. The selection of a proper filling medium 114 depends on a specific application. For instance, filling medium 114 may be printed into the through hole 112. As can be taken from Figure 8, a portion of the filling medium 114 may protrude vertically and/or laterally beyond the stack 102.

Referring to **Figure 9****,** the excessive filling medium 114 on the upper side of the structure of Figure 8 and the horizontal portion of the protection layer 108 on the upper side of the structure of Figure 8 may be removed simultaneously by a common material removal process, such as grinding. Simultaneously or subsequently, the excessive filling medium 114 on the lower side of the structure of Figure 8 and the horizontal portion of the protection layer 108 on the lower side of the structure of Figure 8 may be removed simultaneously by a common material removal process, such as grinding. Thus, the respective removal process may comprise removing selectively the horizontal protection layer 108 and the part of the filling medium 114 extending vertically beyond the horizontal surface of the stack 102. However, the vertical part of the protective film remains in the hole(s) 112 as protection layer residue 110, as indicated by reference sign 152. The protection layer residue 110 may form part of the final component carrier 100 and may function to specifically protect the critical corner regions 150 of the component carrier 100. Hence, the protection layer residue 110 according to Figure 9 may efficiently contribute to edge protection during grinding. This may avoid the formation of additional bumps.

The remaining filling medium 114 shown in Figure 9 may form part of the final component carrier 100. However, it is also possible that the filling medium 114 shown in Figure 9 is only a first filling which may be later removed before completing manufacture of component carrier 100. Thus, the filling medium 114 of Figure 9 may be a temporary filler for temporarily protecting the hole 112 during part of the manufacturing process. Subsequently, such a temporary filling medium 114 may be removed partially or entirely from the hole 112. Optionally, the emptied hole 112 may then be filled by another permanent filling medium.

**Figure 10** illustrates a schematic cross-sectional view of a component carrier 100 according to an exemplary embodiment of the invention.

The component carrier 100 according to Figure 10 differs from the component carrier 100 according to Figure 9 in particular in that, according to Figure 10, the protection layer residue 110 comprises a hollow cylindrical structure lining an entire surface of a sidewall delimiting said hole 112. A further difference of the embodiment of Figure 10 compared with the embodiment of Figure 9 is that, according to Figure 10, a metallic lining 156 lines the entire sidewalls of the through hole 112. Consequently, the hollow cylindrical protection layer residue 110 is circumferentially sandwiched between the exterior hollow cylindrical metallic lining 156 and the interior cylindrical filling medium 114.

Thus, the embodiment of Figure 10 relates to a component carrier 100 with plated holes 112. In particular in such a scenario, the filling medium 114 may for instance be an ink. Part of the protective film remains in the hole and provides surface and hole protection.

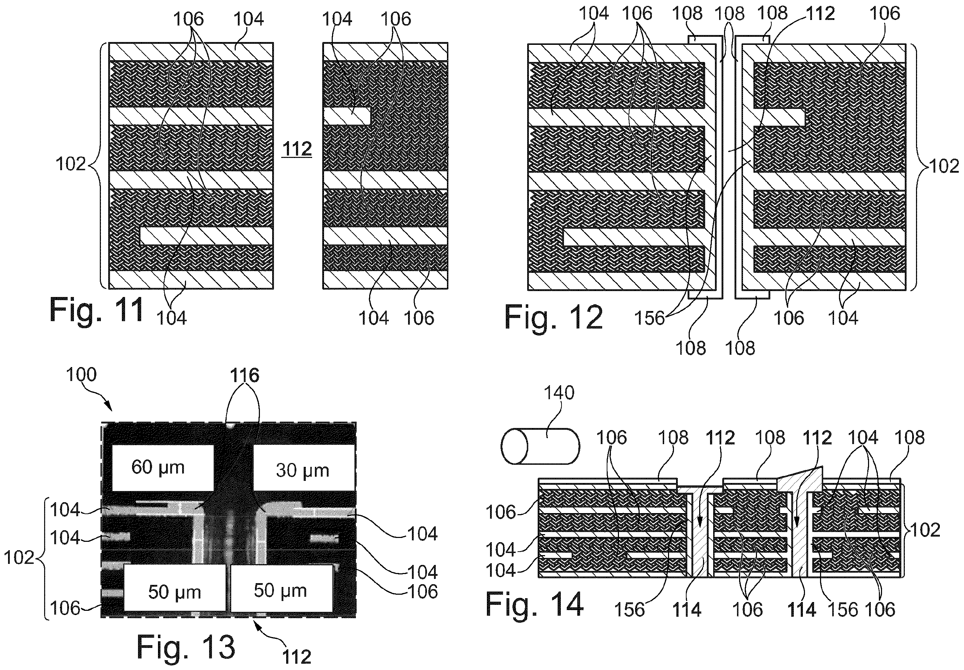

Figure 11 and Figure 12 illustrate cross-sectional views of structures obtained during carrying out a method of manufacturing a component carrier 100 according to an exemplary embodiment of the invention. This embodiment provides only holes protection by selective button plating.

**Figure 11** shows a starting point in form of a laminated layer stack 102 with through hole 112, as described above referring to Figure 6.

Referring to **Figure 12****,** exposed sidewalls of stack 102 may be subjected to a plating process to thereby form hollow cylindrical metallic lining 156 covering the entire sidewalls which delimit the through hole 112. Thereafter, a first part of protection layers 108 may be formed on horizontal surface portions of the stack 102. In addition, another part of the protection layers 108 may be provided to cover the entire exposed sidewalls of metallic lining 156 in the hole 112.

Starting from Figure 12, the remaining empty volume of the through hole 112 may then be filled with a filling medium 114, for instance as described above referring to Figure 8. Thereafter, excessive filling medium 114 and the horizontal portions of the protection layer 108 may be simultaneously removed by grinding, as described referring to Figure 9. By executing such a process flow, a component carrier 100 according to Figure 10 can be obtained.

**Figure 13** illustrates an image of a component carrier 100 according to an exemplary embodiment of the invention. Button plating may be carried out in a selective plating process of plating through holes to provide enough copper in the plated through hole but also to protect the hole prior to an aggressive grinding process. Even after grinding, the copper thickness may be larger in the corner regions than inside of the through holes. Descriptively speaking, such a locally increased copper thickness in the corner regions may function as a copper bump ensuring a high reliability.

**Figure 14** illustrates a cross-sectional view of a structure obtained during carrying out a method of manufacturing a component carrier 100 according to an exemplary embodiment of the invention.

Figure 14 shows a preform of a component carrier 100 in which more than one hole 112 is formed in a layer stack 102 and is filled with a respective metallic lining 156 and filling medium 114. A protection layer 108 is formed on an upper main surface of stack 102 for balancing out an inhomogeneous distribution of the filling medium 114 on and above the through holes 112. By grinding, protection layer 108 and excessive filling medium 114 may be removed simultaneously by executing a common grinding process during which grinding tool 140 is moved in an abrasive way over the entire upper main surface of the structure shown in Figure 14. By grinding, the treated surface will be flattened.

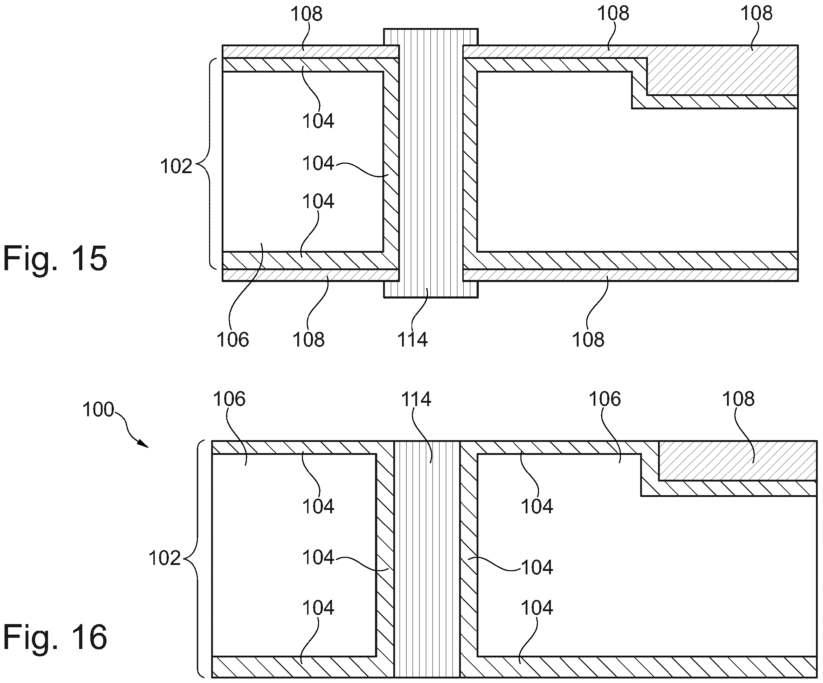

**Figure 15** and **Figure 16** illustrate cross-sectional views of structures obtained during carrying out a method of manufacturing a component carrier 100 according to an exemplary embodiment of the invention. The readily manufactured component carrier 100 is illustrated in Figure 16.

This embodiment shows that a remaining portion of a protection layer 108 may also be arranged at a horizontal surface of the stack 102 and apart from the hole 112.

Thus, even a horizontal part of the protection layer (right part in the example of Figure 15 and Figure 16) may still be left after the removing process, which may act as a mask, for example for a following plating process. After this additional process stage, the remaining part may be (preferably selectively) removed by another removing process. In this context, an additional coating may be done. Hence, such an embodiment may have a two-stage process flow: Coating, grinding, removal; Coating, grinding, removal.

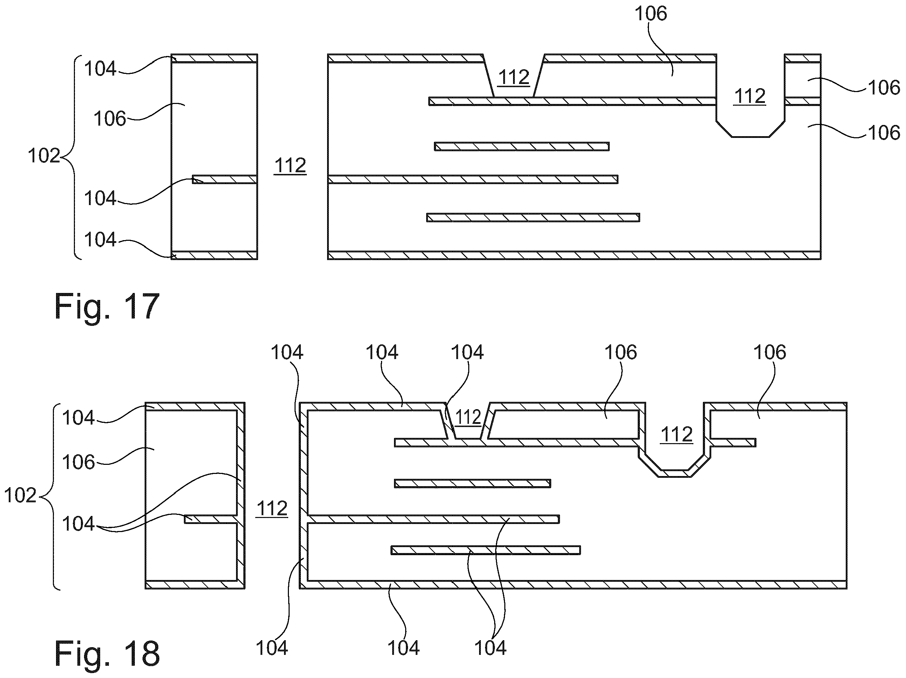

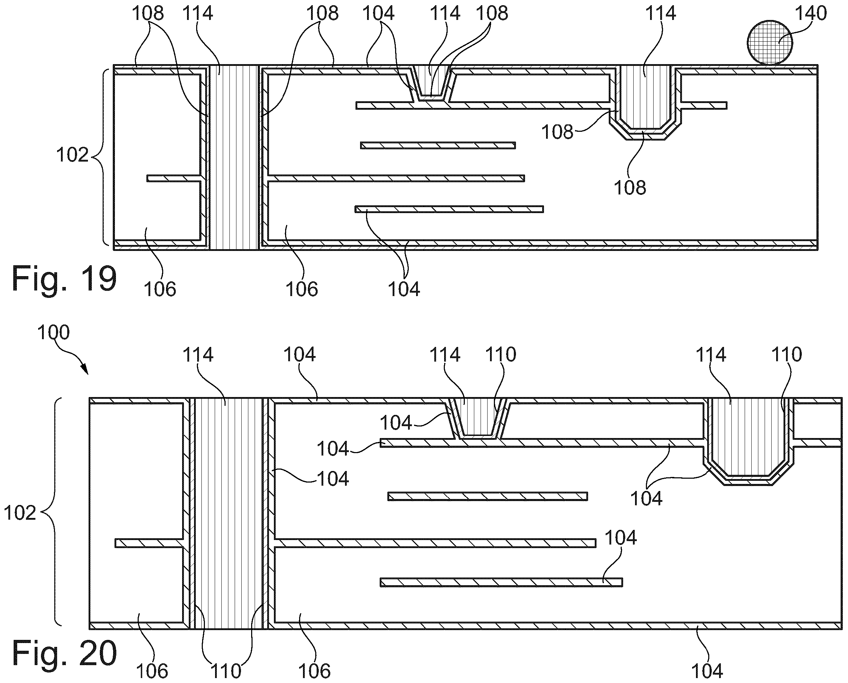

Figure 17, Figure 18, Figure 19 and Figure 20 illustrate cross-sectional views of structures obtained during carrying out a method of manufacturing a component carrier 100 according to an exemplary embodiment of the invention. The readily manufactured component carrier 100 is illustrated in Figure 20.

The embodiment of Figure 17 to Figure 20 shows that the hole 112 is not necessarily a through hole. According to the illustrated embodiment, different holes 112 are shown, i.e. a through hole, a blind hole with tapering shape (which may be a laser hole), and a blind hole with a tapering portion and a portion with vertical sidewalls (which may be a mechanically drilling hole). The bottom of a respective hole 112 may be covered with metallic material, or may be dielectric. Hence, exemplary embodiments may be used for all kinds of holes, and in particular also for all kinds of vias.

Referring to **Figure 17****,** a stack 102 with the mentioned holes 112 is shown.

Referring to **Figure 18****,** the structure of Figure 17 has been subjected to copper plating.

Referring to **Figure 19****,** a sacrificial structure has been formed as protection layer 108, and a resin filling and grinding process has been carried out for forming filling medium 114 in the holes 112.

Referring to **Figure 20****,** exposed portions of the sacrificial structure have been stripped, thereby leaving only protection layer residue 110 lining the various holes 112.

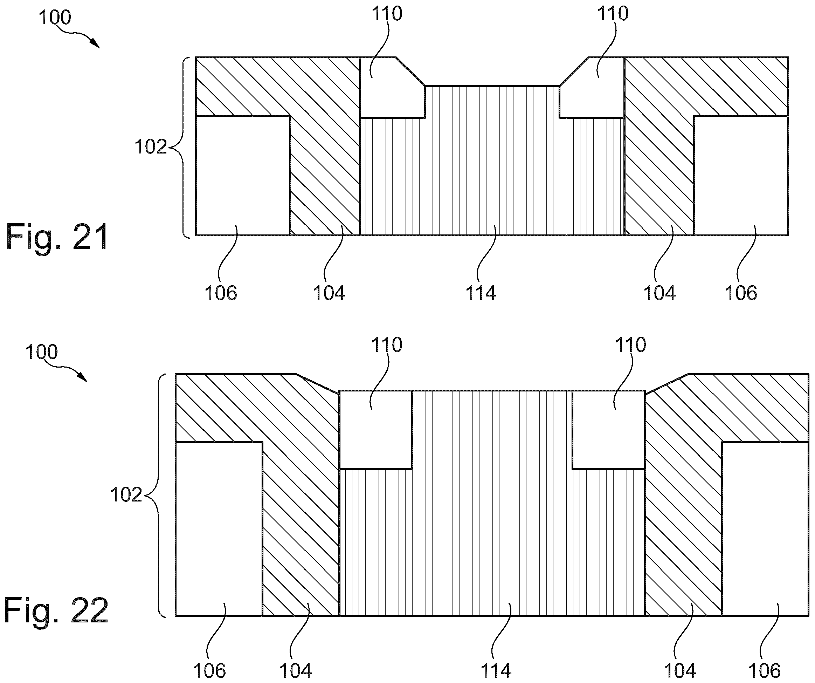

**Figure 21** illustrates a schematic cross-sectional view of a component carrier 100 according to an exemplary embodiment of the invention.

The embodiment of Figure 21 shows that, in a cross sectional view, the protection layer residue 110 can also have a non-rectangular shape.

**Figure 22** illustrates a schematic cross-sectional view of a component carrier 100 according to an exemplary embodiment of the invention.

The embodiment of Figure 22 shows that it be possible that the protection residue 110 and the filling medium 114 may be shifted towards the center of the stack 102. Consequently, the protection layer 110 has no common surface with the exposed surface of the stack 102 in such an embodiment.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants are possible which use the solutions shown and the principle according to the invention even in the case of fundamentally different embodiments.

## Claims

1. A method of manufacturing a component carrier (100), wherein the method comprises:
providing a stack (102) comprising at least one electrically conductive layer structure (104) and at least one electrically insulating layer structure (106) and having a hole (112);
applying a protection layer (108) at least on at least part of a horizontal surface of the stack (102) for protecting the stack (102);
filling a filling medium (114) in and/or on and/or around the hole (112) in the stack (102); and
subsequently removing at least part of the protection layer (108) completely from the horizontal surface and removing material of the filling medium (114) by carrying out a common material removal process.

2. The method according to claim 1, wherein the method comprises applying the protection layer (108) on the entire horizontal surface of at least one main surface of the stack (102), in particular on both opposing main surfaces of the stack (102).

3. The method according to claim 1 or 2, wherein the method comprises applying part of the protection layer (108) on at least part of a slanted or vertical surface of the hole (112) extending into, in particular through, the stack (102).

4. The method according to any of claims 1 to 3, wherein the method comprises applying the protection layer (108) on said at least part of the horizontal surface of the stack (102) and on a connected part of a slanted or vertical surface of the hole (112) extending into, in particular through, the stack (102).

5. The method according to any of claims 1 to 4, wherein the method comprises applying another part of the protection layer (108) to cover an entire sidewall of the hole (112).

6. The method according to any of claims 1 to 5, wherein said removing comprises removing selectively the part of said filling medium (114) extending vertically beyond the horizontal surface of the stack (102).

7. The method according to any of claims 1 to 6, wherein the common material removal process is a pure mechanical grinding process, a pure chemical material removal process, or a combined mechanical grinding and chemical material removal process.

8. The method according to any of claims 1 to 7, comprising at least one of the following features:
wherein the method comprises removing the protection layer (108) completely by said common material removal process;
wherein the method comprises removing only part of the protection layer (108) by said common material removal process without removing a protection layer residue (110);
wherein the method comprises forming the protection layer (108) using an organic material, in particular polyimide and/or a resin, more particularly an epoxy resin.

9. A component carrier (100), which comprises:
a stack (102) comprising at least one electrically conductive layer structure (104) and at least one electrically insulating layer structure (106) and having a hole (112); and
a protection layer residue (110) arranged in the hole (112) and configured for protecting material of the stack (102) during at least part of a process of manufacturing the component carrier (100).

10. The component carrier (100) according to claim 9, wherein the protection layer residue (110) lines at least part of a sidewall of the hole (112), in particular a through hole, extending into the stack (102).

11. The component carrier (100) according to claim 10, wherein the protection layer residue (110) comprises an annular structure at an exterior end of said hole (112).

12. The component carrier (100) according to any of claims 9 to 11, wherein the protection layer residue (110) is a circumferentially closed structure in the hole (112) in the stack (102).

13. The component carrier (100) according to any of claims 9 to 12, wherein the protection layer residue (110) comprises a material adhering to copper material, in particular to copper material of the at least one electrically conductive layer structure (104).

14. The component carrier (100) according to any of claims 9 to 13, wherein the protection layer residue (110) comprises a dielectric material, in particular a dry film material, and/or the protection layer residue (110) comprises a metallic material, in particular nickel, palladium, and/or hardened or oxidized copper.

15. The component carrier (100) according to any of claims 9 to 14, comprising at least one of the following features:
wherein a thickness (D) of a plated electrically conductive layer (116) at an edge between a horizontal surface of the stack (102) and the hole (112) extending in the stack (102) is at least 5 µm, in particular at least 20 µm;
wherein a ratio between a thickness (D) of a plated electrically conductive layer (116) at an edge between a horizontal surface of the stack (102) and the hole (112) extending in the stack (102) on the one hand and a thickness (d) of said plated electrically conductive layer (116) apart from the edge, in particular at the horizontal surface and/or in the hole (112), is larger than 1, in particular is in a range from 1.1 to 1.3;
wherein the protection layer residue (110) comprises an organic material, in particular polyimide and/or a resin, more particularly an epoxy resin.
